# EUROPEAN PATENT SPECIFICATION

(11) **EP 3 823 076 B1**
(45) Date of publication and mention of the grant of the patent: **08.05.2024**
(21) Application number: 19208572.8
(22) Date of filing: 12.11.2019
(51) Int. Cl.: H01M 10/42, H01M 10/48, G01R 1/20, G01R 31/364, H01M 50/502

(54) **SENSOR SYSTEM FOR A BATTERY MODULE**
SENSORSYSTEM FÜR EIN BATTERIEMODUL
SYSTÈME DE CAPTEUR POUR UN MODULE DE BATTERIE

(43) Date of publication of application: 19.05.2021
(73) Proprietor: Samsung SDI Co., Ltd., Gyeonggi-do 17084 (KR)
(72) Inventor: Hofer, Maximilian, 8230 Hartberg (AT); Pretschuh, Markus, 8020 Graz (AT)
(74) Representative: Gulde & Partner

(56) References cited:
- US-A1- 2011 089 931
- US-A1- 2013 328 547
- US-A1- 2014 015 515

## Description

### Field of the Invention

The present invention relates to a battery system for a battery module, particularly to a sensor system for measuring a current off a battery system. The sensor system comprises a shunt resistor and thermoelectric effects on the shunt resistor are taken into consideration.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of battery cells coupled in series and/or in parallel so as to provide a high energy density, e.g. for motor driving of a hybrid vehicle. That is, the battery module is formed by interconnecting the electrode terminals of the plurality of battery cells depending on a required amount of electric power and in order to realize a high-power rechargeable battery, e.g. for an electric vehicle.

For meeting the dynamic power demands of various electrical consumers connected to the battery system, a static control of battery power output and charging is not sufficient. Thus, steady exchange of information between the battery system and the controllers of the electrical consumers is required. This information include the battery system's actual state of charge (SoC), potential electrical performance, charging ability and internal resistance as well as actual or predicted power demands or surpluses of the electric consumers.

Battery systems usually comprise a battery management system (BMS) and/or battery management unit (BMU) for processing the aforementioned information. The BMS/BMU may communicate to the controllers of the various electrical consumers via a suitable communication bus, e.g. a SPI or CAN interface. The BMS/BMU may further communicate with each of the battery (sub)modules, particularly with a cell supervision circuit (CSC) of each battery (sub)module. The CSC may be further connected to a cell connection and sensing unit (CCU) of a battery (sub)module that interconnects the battery cells thereof. The CCU may further provide a voltage sensing signal of one or more battery cells of the (sub)module and process such voltage sensing signal itself or provide it to the CSC.

A Lithium ion battery system usually requires monitoring a voltage of the battery cells as over- and undervoltage might pose a security risk and might lower the service life of the system. Further the current of the battery system is detected in order to derive the actual SOC, e.g. by current-time-integration. A common method for measuring the battery current is to introduce a shunt with precisely known small ohmic resistance in the current path of the battery system. By measuring the voltage drop over the shunt, the current can be determined using the known resistance. As the voltage drop over the shunt is preferably small, a highly accurate voltage detection system is required and is thus usually realized on the CCU and/or the CSC.

Usual shunt resistors utilized for measuring currents occurring in battery systems comprise two current clamps that are configured to be respectively connected to the current path, for which a current shall be measured. The two current clamps of the shunt resistor are connected by the actual measurement resistance, which is usually formed by a suitable alloy, such as e.g., Manganin, Isotan, or the like. As the current clamps are not formed of the cost-intensive alloy of the measurement resistance but are usually formed of copper or aluminum or the like, a thermoelectric effect can along the different components of the shunt resistor.

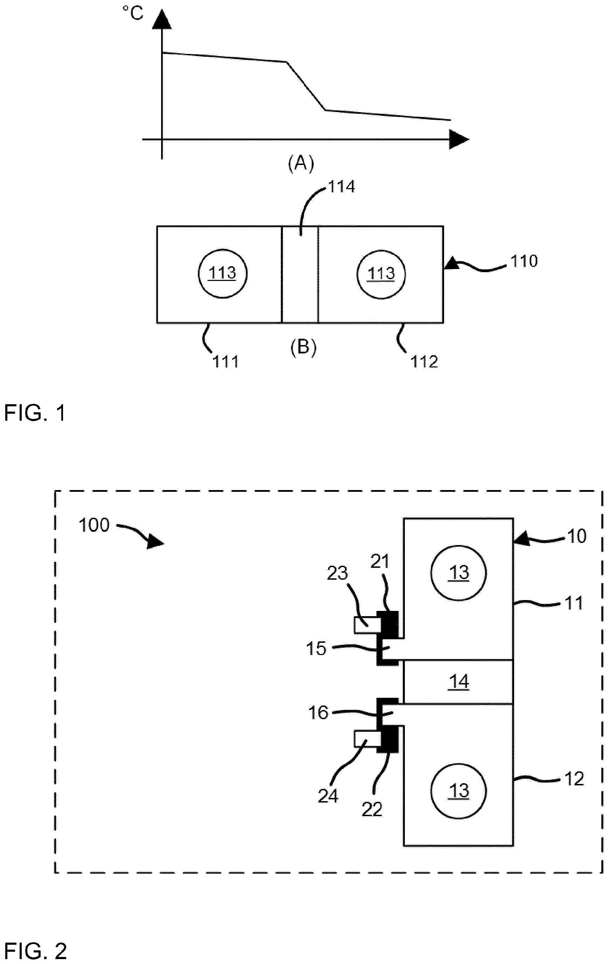

Hence, as different metals are used for forming the shunt resistor, the thermoelectric effect of these metals can negatively and significantly impact the current measurement results. The problem is illustrated with respect to Figure 1, wherein Figure 1(A) illustrates a usual shunt resistor 110 as commonly used for current measurements via voltage sensing. The shunt resistor 110 of Figure 1(A) comprises a first current clamp 111 and a second current clamp 112 that are each formed of metal and each comprise a hole 113 for being connected to a current path, particularly to column shaped terminals of battery cells (not shown). The first and second current clamps 111, 112 are connected to each other via the measurement resistance 114 formed of Manganin. By measuring a voltage drop across the shunt resistor 110, particularly across the measurement resistance 114, the current across the shunt resistor 110 can be determined. In order to avoid influence of transition resistances at the connections to the battery module, the voltages are preferably measured directly adjacent to the measurement resistance 114, e.g., via wire bonds connected to a measurement circuit.

As further shown in Figure 1 (B), the temperature at the first current clamp 111 significantly exceeds the temperature at the second current clamp 112. This temperature step may have different reasons, such as e.g., that a relay is positioned adjacent the first current clamp 111 and inputs additional heat to the first current clamp 111. Also, adjacent the second current clamp 112 a connection to a vehicle or to another heat sink may be formed that significantly lowers the temperature of the second current clamp 112. The largest temperature gradient is formed in the measurement resistance 114 due to the high thermal resistance of the alloy.

If the temperature gradient over the shunt resistor 110 is known, the thermoelectric effect can be compensated by calculation in determining the current from the voltage measurement. However, thermal coupling between a temperature sensor element and a shunt resistor 10 is complex as a shunt resistor 110 is usually mounted to a circuit carrier, such as a printed circuit board, PCB, or directly to a battery module. So far, temperature sensors are often mounted via a thermal glue to a shunt resistor, which is an expensive and complex process that is also difficult to integrate in the production of battery system electronic systems.

US 2013/328547 A1 refers to a shunt resistor that shall reduce errors in a derived current value that arise because of thermoelectric voltages arising between a resistor and the clamps by fulfilling a variety of requirements, e.g., by that connecting points for voltage sensing lines are located in a central element of the shunt, the material of sensing lines is the same as that of the central element, the sensing lines shall be attached to the central element without additional material, both sensing lines terminate in a common isothermal block area and both sensing lines extend well past the surface as well as the edge of the shunt.

It is thus an object of the present invention to overcome or reduce at least some of the drawbacks of the prior art and to provide a sensor system for current measurements that considers thermal effects and can be easily integrated in control units for battery systems.

### Description of the invention

One or more of the drawbacks of the prior art could be avoided or at least reduced by means of the present invention. In particular, a sensor system for a battery module is provided, in detail a measurement system for measuring a current within or of the battery module.

The sensor system of the present invention comprises a shunt resistor that has at least the following components. The shunt resistor at least comprises a first current clamp and a second current clamp, wherein the first current clamp and the second current clamp are each configured to be connected to a current path of the battery module. In other words, the shunt resistor is configured to be integrated in a current path of the battery module, wherein a current shall be measured along the current path. The shunt resistor is integrated in the current path by connecting the first current clamp and the second current clamp thereto. According to the present invention, the shunt resistor further comprises a first voltage clamp and a second voltage clamp. Therein, the voltage clamps are configured to tap the voltage signals from the shunt resistor, e.g., for providing them to a voltage measurement circuit.

The shunt resistor of the sensor system of the present invention further comprises a measurement resistance that is electrically connecting the first current clamp and the second current clamp. In other words, the measurement resistance is disposed between the first current clamp and the second current clamp and preferably also connects the current clamps mechanically. The measurement resistance has an ohmic resistance of precisely defined value. Preferably, the measurement resistance has an ohmic resistance that is adapted to the magnitude of the current to be measured. Typical measurement resistances used in battery modules have an ohmic resistance of 100 µΩ. However, due to the increasing currents of modem battery modules, the measurement resistance may also have an ohmic resistance smaller than 100 µΩ, particularly preferred an ohmic resistance of 50 µΩ or 25 µΩ. The measurement resistance is disposed in between the first voltage clamp and the second voltage clamp, wherein the voltage clamps are positioned adjacent the measurement resistance. Preferably, the voltage clamps are positioned directly adjacent to the measurement resistance. Hence, the measurement resistance is also electrically, and preferably mechanically, connecting the first voltage clamp and the second voltage clamp. However, additional (electrically insulating) mechanical connection means may also be used.

The sensor system of the present invention further comprises a first landing pad that is electrically connected to the first voltage clamp and a second landing pad that is electrically connected to the second voltage clamp. Hence, the first landing pad is configured to receive a first voltage signal from the first voltage clamp, i.e., is at the same electric potential as the first voltage clamp. The second landing pad is configured to receive a second voltage signal from the second voltage clamp, i.e., is at the same electric potential as the second voltage clamp. The landing pads are thus contact pads that are electrically connected to the voltage clamps. The landing pads are separate from and independent of the shunt resistor. Preferably, the landing pads do not constitute a part of the shunt resistor.

The sensor system of the present invention further comprises a first temperature sensor that is connected to the first landing pad and a second temperature sensor that is connected to the second landing pad. The first temperature sensor is configured to measure a temperature of the first landing pad and is preferably at the same temperature as the first landing pad (at least in thermal equilibrium). The second temperature sensor is configured to measure a temperature of the second landing pad and is preferably at the same temperature as the second landing pad (at least in thermal equilibrium).

According to present invention, a sensor system for a battery module is provided that allows for current measurements in a battery module under consideration of thermal effects. Particularly, the sensor system provides a simple solution for measuring a temperature drop along (across) a shunt resistor in addition to a voltage drop along (across) the shunt resistor. Hence, the sensor system allows for highly precise current measurements via the shunt.

According to the present invention, an excellent thermal coupling between temperature sensors and the shunt is realized by coupling the temperature sensors to the landing pads (contact pads) for the voltage clamps of the shunt resistor. These landing pads have to be provided for tapping the voltage signals from the shunt resistor when measuring the voltage drop over the measurement resistance in order to determine the current through the shunt. Hence, advantageously no additional structures are required for thermally coupling the temperature sensors to the shunt and also the whole sensor system can be surface mounted.

According to a preferred embodiment of the present invention, a sensor system is provided wherein the first current clamp and the second current clamp each comprises at least one contact hole that is configured for being connected to a terminal of at least one battery cell. Particularly preferred, each of the contact holes is configured to be fit onto a column-shaped or cylindrical terminal of a battery cell. In other words, the shunt resistor might be configured as a busbar for connecting cell terminals of at least two battery cells. Preferably, the shunt resistor is part of a cell connecting unit, CCU, or cell supervision circuit, CSC, mounted on top of a battery module. Further, the shunt resistor may be a busbar electrically connecting cell terminals of two battery cells electrically connected in series within the battery module. Also preferred, each contact hole is configured for allowing a tool to be inserted there through, e.g., a tool for welding the respective current clamp to a terminal of at least one battery cell. Further preferred, the contact holes improve the heat dissipation from the shunt resistor.

In a particularly preferred embodiment, the first current clamp is configured to be electrically connected to at least one first cell terminal of a first polarity and the second current clamp is configured to be electrically connected to an equal amount of second cell terminals of a second polarity. Further preferred, the current clamps are adapted in material, size and shape to the respective battery cell terminals to which they shall be connected. The first current clamp and the second current clamp are preferably configured to be connected to one or more of the respective cell terminals. Particularly, the respective current clamps elements are configured to be connected to a plurality of terminals of battery cells connected in parallel.

Further preferred, the first current clamp comprises the same material or consists of the same material as the first cell terminals of the first polarity. Thus, bimetallic corrosion is advantageously avoided. Therein, the material of the whole first current clamp or only of a contact region configured to actually contact the first terminal(s) is adapted to the material of the first terminal(s). Further preferred, the second current clamp comprises the same material or consists of the same material as the second cell terminals of the second polarity. Thus, bimetallic corrosion is advantageously avoided. Therein, the material of the whole second current clamp or only of a contact region configured to actually contact the second terminal(s) is adapted to the material of the second terminal(s). However, the first current clamp and the second current clamp may also be formed of the same material, e.g., copper or aluminum.

Further preferred, the measurement resistance comprises or consists of Manganin, Constantan, Isotan, Isabellin and/or another material with thermally stable ohmic resistance. Further preferred, the voltage clamps are of the same material as the respective current clamp, i.e., the first voltage clamp is of the same material as the first current clamp and the second voltage clamp is of the same material as the second current clamp. Particularly preferred, the first and second voltage clamp comprise or consist of copper or aluminum.

In a particularly preferred embodiment of the present invention, the sensor system further comprises a circuit carrier that is configured for carrying a control unit of the battery module.

The circuit carrier preferably is a rigid circuit board, a flexible circuit board, FCB, or a combination thereof. The rigid circuit carrier may comprise a plurality of conductive structures, e.g., formed as metallization or from conductive polymer and thus be a printed circuit board, PCB. The flexible circuit board may also comprise a plurality of conductive structures formed as metallizations or from conductive polymers and may thus be a printed flexible circuit, FPC.

According to this embodiment, the first landing pad and the second landing pad are formed as conductive structures on a surface of the circuit carrier. The conductive structures are preferably metallizations or formed from conductive polymers. Further preferred, the surface is a first main surface of a flat and extended planar circuit carrier. According to this embodiment, the shunt resistor is mounted to the (first main) surface of the circuit carrier. In other words, the shunt resistor is mechanically affixed to the (first main surface) and the voltage clamps of the shunt resistor are electrically (and thermally) connected to the respective landing pads on the first main surface. Preferred, the first and second voltage clamps of the shunt resistor are soldered, welded or wire-bonded to a respective landing pad.

Further preferred, according to this embodiment, the temperature sensors are surface mounted to the (first main) surface of the circuit carrier. In other words, according to this embodiment, the shunt resistor, the landing pads and the temperature sensors are configured as surface mounted devices, SMD. The first and second temperature sensors are preferably electrically and thermally connected to the respective landing pad. This preferred embodiment advantageously allows for a particular easy assembling and mounting of the sensor system of the invention using only standard processes of microelectronic engineering.

Further preferred, the first temperature sensor of the sensor system of the present invention is a first thermistor and the second temperature sensor of the sensor system of the present invention is a second thermistor. Further preferred, the temperature sensors are either negative temperature coefficient, NTC, thermistors or positive temperature coefficient, PTC, thermistors, wherein preferably both temperature sensors are of the same kind. This embodiment advantageously utilizes the combined thermal and electric connection of the temperature sensors to the respective landing pad of the sensor system. However, in principle the sensor system can also be realized with other types of temperature sensors. Advantageously, any kind of temperature sensor benefits from the thermal coupling between the voltage clamps of the shunt resistor and the (metallization) of the respective landing pad.

According to a further preferred embodiment of the sensor system, the first current clamp is configured as a first bar element and the second current clamp is configured as a second bar element. In other words, each of the current clamps is preferably configured as a planar flat component. Further preferred, in this embodiment the measurement resistance is configured as a third bar element that is connecting the first bar element and the second bar element. According to this embodiment, the first and second bar elements, i.e., the first and second current clamps, together with the third bar element, i.e., the measurement resistance, form a common bar that is extending in a lengthwise direction. Hence, the shunt resistor of this embodiment is particularly simple to manufacture and to handle in battery module assembly.

According to this preferred embodiment, the first voltage clamp is preferably formed as a first protrusion that is extending from the first bar element in a direction angled to the lengthwise direction, particularly preferred in a direction perpendicular to the lengthwise direction. Further, the second voltage clamp is preferably formed as a second protrusion that is extending from the second bar element in a direction angled to the lengthwise direction, particularly preferred in a direction perpendicular to the lengthwise direction. Providing additional voltage clamps, as in this embodiment, advantageously increases the measurement accuracy as transition resistances at the contact points of the current clamps and the current path, which might exceed the measurement resistance, do interfere less with the voltage measurements. Further, voltage clamps formed by angled protrusions simplify the electric and thermal connection of these voltage clamps to the landing pads of the system.

According to a further preferred embodiment of the sensor system of the invention, the first voltage clamp is connected via the first landing pad to a first voltage sensing line. Therein, the first voltage sensing line is configured to receive a first voltage signal via the first landing pad from the first voltage clamp. Therein, the first voltage signal is indicative of a voltage (electric potential) at the first voltage clamp. The first voltage line is a conductive structure on the (first main) surface of the circuit board and is preferably formed as a metallization or of conductive polymer. The first voltage line is further preferably configured to transmit the received first voltage signal to a voltage measurement circuit that might be disposed on the circuit board. Further, preferred the first voltage clamp is connected via the first landing pad and the first temperature sensor to a first temperature sensing line. Therein, the first temperature sensing line is configured to receive a first temperature signal from the first temperature sensor, wherein the first temperature signal is indicative of the temperature of the first voltage clamp. The first temperature sensing line is further preferably configured to transmit the first temperature signal to a temperature measurement circuit, e.g. on the circuit board.

According to a further preferred embodiment of the sensor system of the invention, the second voltage clamp is connected via the second landing pad to a second voltage sensing line. Therein, the second voltage sensing line is configured to receive a second voltage signal via the second landing pad from the second voltage clamp. Therein, the second voltage signal is indicative of a voltage (electric potential) at the second voltage clamp. The second voltage line is a conductive structure on the (first main) surface of the circuit board and is preferably formed as a metallization or of conductive polymer. The second voltage line is further preferably configured to transmit the received second voltage signal to a voltage measurement circuit that might be disposed on the circuit board. Further preferred, the second voltage clamp is connected via the second landing pad and the second temperature sensor to a second temperature sensing line. Therein, the second temperature sensing line is configured to receive a second temperature signal from the second temperature sensor, wherein the second temperature signal is indicative of the temperature of the second voltage clamp. The second temperature sensing line is further preferably configured to transmit the second temperature signal to a temperature measurement circuit, e.g., on the circuit board. In this embodiment, the first and second temperature sensor preferably both are thermistors.

In the preferred embodiment described above, a thermal coupling between the first landing pad and at least one of the first voltage sensing line and the first temperature sensing line is decreased (limited/lowered). Further preferred, also a thermal coupling between the second landing pad and at least one of the second voltage sensing line and the second temperature sensing line is decreased (limited/lowered). As set forth above, the sensing lines are configured to transmit respective (electric) signals to respective measurement circuits. As electric conductivity comes along with thermal conductivity, the landing pads are thus also thermally connected to the respective measurement circuits. However, in order to limit the thermal influence of these measurement circuits on the landing pads, i.e., in order to increase the accuracy of the temperature measurement at the landing pads, the thermal coupling of at least some of those sensing lines and the respective landing pads is preferably decreased.

In a particularly preferred embodiment, the thermal coupling of the landing pads from the respective sensing lines is decreased (lowered/limited) by an at least local thinning of the voltage sensing lines and/or the temperature sensing lines. In other words, the thermally conductive cross section of the respective sensing lines is preferably decreased. Particularly preferred, the thinning is disposed adjacent to the respective landing pad. A local thinning reduces the thermally conductive cross section of a sensing line along a fraction of the extension of the sensing line. However, the thinning may also extend along the whole extension of the sensing line, such that the whole sensing line is dimensioned such that thermal propagation along the sensing line is negligible. A reduction of thermal coupling by an at least local thinning of a sensing line is advantageously simple to realize in common structuring methods of microelectronic structures, e.g., by photolithographic techniques.

As set forth above the first and second voltage sensing line are configured to receive a respective first and second voltage signal, Sens+ and Sens-, from the respective first and second landing pad. The first and second voltage sensing lines are further configured to provide the first and second voltage signals to at least one voltage measurement circuit. However, individual voltage measurement circuits may be used for the first and second voltage signal. Particularly preferred, a single voltage measurement circuit is disposed on the circuit board and is configured for receiving the first voltage signal and the second voltage signal. The at least one voltage measurement circuit is configured to determine a voltage value, e.g., a digitally coded voltage value, based on the analogue first and second voltage signals. The voltage measurement circuit preferably receives at least one reference voltage and comprises at least one comparator, particularly preferred a plurality of comparators.

As further set forth above, the first and second temperature sensing lines are configured to receive first and second temperature signals, TMP1 and TMP₂, from the respective first and second voltage sensor. The first and second temperature sensing lines are further configured to provide (transmit) the first and second temperature signals to at least one temperature measurement circuit. However, individual temperature measurement circuits may be used for the first and second temperature signal. Particularly preferred, a single temperature measurement circuit is disposed on the circuit board and is configured for receiving the first temperature signal and the second temperature signal. The temperature measurement circuit is further configured to determine a temperature value, e.g., a digitally coded voltage value, based on the analogue first and second temperature signal. The temperature measurement circuit preferably receives at least one reference voltage and comprises at least one operational amplifier, a comparator, particularly preferred a plurality of comparators.

In the above described preferred embodiment, the first and second temperature sensors are preferably configured as a first and second thermistor. Hence, the first and second temperature signals are easily obtained as electric signals by applying a reference voltage to each of the first and second temperature sensors. The voltage on the respective temperature sensing line then depends on the electric resistance of the first temperature sensor thermistor and the second temperature sensor thermistor, respectively, wherein these electric resistances itself are dependent on the temperature of the respective first and second landing pad that is thermally and electrically connected to the respective temperature sensors. Further preferred in this embodiment, a reference voltage node is connected to the first temperature sensing line and to the second temperature sensing line. However, also different reference voltage nodes may be connected to the temperature sensing lines, respectively.

According to the above embodiment, the voltages on the temperature sensing lines depend on the reference voltage and the temperature-dependent resistance of the thermistors. These voltages on the temperature sensing lines are also coupled via the landing pads to the shunt resistor and will thus cause an additional current trough the shunt resistor. As such additional current might interfere with the current measurement, the at least one reference voltage node is preferably connected via a first resistor to the first temperature sensing line and via a second resistor to the second temperature sensing line. Therein, the ohmic resistance of the first and second resistor is preferably set to significantly limit the additional current based on the reference voltage over the shunt resistor, preferably to a current of 500 µA or below. The first and second resistors are preferably connected in series with the shunt resistor and hence the additional current through the shunt resistor is effectively limited. Further preferred, each of the first and the second temperature sensor is connected to ground via the shunt resistor.

According to the above embodiment, the voltage drop over the shunt resistor might also influence the temperature signals on the first and second temperature sensing lines due to the different reference voltages. These different reference voltages may contribute to a potential error in temperature measurement, if the difference is not considered during temperature determination based on the first and second temperature signal. Hence, the voltage measurement circuit and the temperature measurement circuit are preferably configured to communicate with each other. Hence, the voltage measurement circuit can inform the temperature measurement circuit about the voltage drop over the shunt resistor, particularly over the measurement resistance, for enabling the temperature measurement circuit to account for different reference voltages applying to the temperature sensors.

In a further preferred embodiment, the circuit carrier of the sensor system carries a cell supervision circuit, CSC, connected to the battery module and configured to receive voltage and temperature signals for at least one battery cell of the battery module. The CSC may further be configured to process these signals and/or to perform active and/or passive balancing of the battery cells of the battery module. The CSC may further be configured to communicate with further CSCs and/or a battery management system, BMS. Further preferred, the circuit carrier of the sensor system carries or is configured as a cell connecting unit, CCU, connected to the battery module and configured for connecting at least one battery cell to a CSC. The CCU may comprise the circuit carrier and a plurality of landing pads, temperature sensing lines and voltage sensing lines as well as further mounting pads. Further preferred, the circuit carrier carries a battery management unit, BMU, or a BMS configured for performing high level control operations with respect to the battery module, including emergency shut-off of battery cells, battery (sub)modules or the battery system, charging, SOC estimation and communication with electrical loads connected to the BMS.

Further aspects of the present invention are disclosed in the dependent claims, the appended drawings and the following detailed description of the appended drawings.

### Brief Description of the Drawings

Features will become apparent to those of ordinary skill in the art by describing in detail exemplary embodiments with reference to the attached drawings in which:
- Fig. 1: (A) schematically illustrates a shunt resistor according to the prior art and (B) a temperature profile along the shunt resistor of the prior art;
- Fig. 2: schematically illustrates a sensor system according to an embodiment;
- Fig. 3: schematically illustrates a sensor system according to another embodiment;
- Fig. 4: schematically illustrates a sensor system according to another embodiment; and
- Fig. 5: illustrates a circuit diagram of a sensor system according to an embodiment.

### Detailed Description of the Drawings

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted.

Figure 1 has already been described in the introduction and a repeated description is omitted.

Figure 2 schematically illustrates a sensor system 100 according to an embodiment of the present invention. The sensor system 100 comprises a shunt resistor 10 that is configured to be integrated in a current path (not shown), particularly in a current path of a battery module.

Therefore the shunt resistor 10 comprises a first current clamp 11 and a second current clamp 12 that are bar-shaped pieces of metal and each comprise a contact opening 13. The contact opening 13 is configured to facilitate the connection of the shunt resistor 10 to the current path, e.g., to cell terminals of battery cells (not shown) of the battery module. Therein, the terminal may be inserted through the contact opening 13 or a weld operation may be performed though the contact opening 13. The metal material of the first current clamp 11 and of the second current clamp 12 is preferably adapted to the material of the cell terminals.

The first current clamp 11 and the second current clamp 12 are separated from each other by a measurement resistance 14 that is disposed between the first current clamp 11 and the second current clamp 12. The measurement resistance 14 is formed of Manganin and comprises a precisely determined ohmic resistance of 75 µΩ that is substantially stable with respect to temperature changes. The shunt resistor 10 further comprises a first voltage clamp 15 that protrudes from the first current clamp 11 in a direction perpendicular to a lengthwise direction of the shunt resistor 10, wherein the lengthwise direction extends from the first current clamp 11 over the measurement resistance 14 to the second current clamp 12. The shunt resistor 10 further comprises a second voltage clamp 16 protruding from the second current clamp 12 in a direction perpendicular to the lengthwise direction of the shunt 10.

The first voltage clamp 15 of the shunt resistor 10 is connected to a first landing pad 21 of the sensor system 100 and the second voltage clamp 16 is connected to a second landing pad 22 of the sensor system 100. Therein, each of the first landing pad 21 and the second landing pad 22 is a copper contact pad. The size of the first landing pad 21 exceeds the size of the first voltage clamp 15. Particularly, the width of the first landing pad 21 in lengthwise direction of the shunt resistor 10 exceeds the width of the first voltage clamp 15 in the lengthwise direction. The size of the second landing pad 22 exceeds the size of the second voltage clamp 16. Particularly, the width of the second landing pad 22 in the lengthwise direction exceeds the width of the second voltage clamp 16 in the lengthwise direction of the shunt 10.

That the size of the landing pads 21, 22 exceeds the size of the respective voltage clamp 15, 16 benefits the connection of a first temperature sensor 23 to the first landing pad 21 and the connection of a second temperature sensor 24 to the second landing pad 22. The temperature sensors 23, 24 are thermally connected to the respective landing pad 21, 22 and the respective landing pad 21, 22 is thermally connected to the respective voltage clamp 15, 16. Hence, the sensor system 100 of the invention allows to accurately measure the temperatures of the voltage clamps 15, 16 and hence the temperature gradient of the shunt resistor 10 without requiring a complicated bonding concept of the sensors 23, 24.

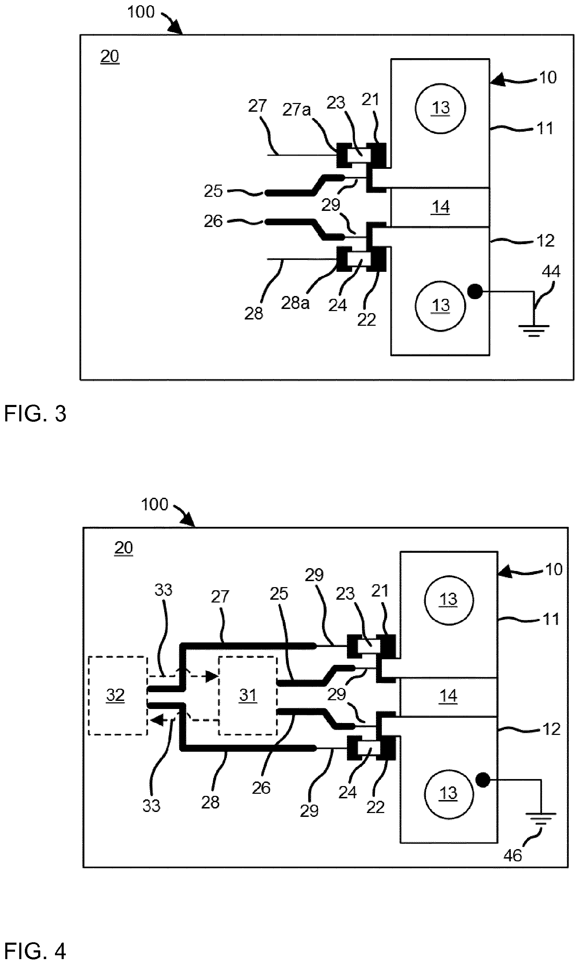

Figure 3 schematically illustrates a sensor system 100 according to another embodiment. Therein, the sensor system 100 further comprises a circuit carrier 20 that is configured to carry the components of the sensor system 100 as surface mounted devices, SMD. The circuit carrier 20 is planar and comprises a first main surface facing the viewer and a second main surface (not shown) opposite the first main surface. The shunt resistor 10 is adhered to the first main surface with an insulating glue and is connected to a current path of a battery module by inserting cell terminals of battery cells of the battery module through the contact holes 13 and through corresponding holes of the circuit carrier 20 aligned with the holes 13.

According to this embodiment, the first and second landing pad 21, 22 are formed as copper surface metallizations on the first main surface of the circuit carrier 20. Further, a first voltage sensing line 25 is connected to the first landing pad 21 and a second voltage sensing line 26 is connected to the second landing pad 22. The first and second voltage sensing lines 25, 26 are also formed as copper surface metallizations on the first main surface of the circuit carrier 20. A local thinning 29 is formed in each of the first and second voltage sensing lines 25, 26 adjacent to the respective first and second landing pad 21, 22. The local thinning 29 serves to decrease thermal coupling between the voltage sensing lines 25, 26 and the respective landing pad 21, 22 by reducing the thermally conductive cross-section of the voltage sensing lines 25, 26 adjacent to the respective first and second landing pad 21, 22.

Further, a first temperature sensing line 27 is connected to the first temperature sensor 23 via a first sensor pad 27a and a second temperature sensing line 28 is connected to the second temperature sensor 24 via a second sensor pad 28a. The temperature sensing lines 27, 28 and the sensor pads 27a, 28a are also formed as copper surface metallizations on the circuit carrier 20. The cross-sections of the whole temperature sensing lines 27, 28 correspond to the cross-section of the local thinning 29 in the first or second voltage sensing line 25, 26 such that a thermal conductivity of the temperature sensing lines 27, 28 is negligible.

According to this embodiment, the first voltage sensing line 25 taps a first voltage signal from the first landing pad 21, wherein the first voltage signal corresponds to the voltage potential at the first voltage clamp 15. Further, the second voltage sensing line 26 taps a second voltage signal from the second landing pad 22, wherein the second voltage signal corresponds to the voltage potential at the second voltage clamp 16. Hence, the combination of the first and second voltage signals is indicative of the voltage drop over the shunt resistor 10 and can be evaluated by a voltage measurement circuit comprising e.g., a differential amplifier or the like.

Further, according to this embodiment, the first temperature sensing line 27 taps a first temperature signal from the first temperature sensor 23 and the second voltage sensing line 28 taps a second temperature signal from the second temperature sensor 24. Therein, each of the first and second temperature signals might be an output of the respective temperature sensor 23, 24 or might be a signal, e.g., a voltage, influenced by the temperature sensors 23, 24. Hence, the first temperature signal is indicative of the temperature at the first landing pad 21 and thus at the first voltage clamp 15 and the second temperature signal is indicative of the temperature at the second landing pad 22 and thus at the second voltage clamp 16.

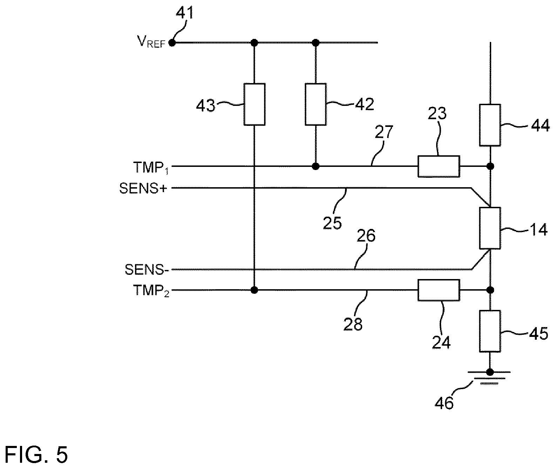

According to this embodiment, the first temperature sensor 23 is a first NTC thermistor and the second temperature sensor 24 is a second NTC thermistor. In order to derive the respective temperature signals via the first and respective temperature sensors 23, 24 a reference voltage is applied to the temperature sensors 23, 24 as shown in Figure 5. Further, each of the first and second temperature sensor 23, 24 is connected to ground 44 via the shunt resistor 10. Hence, the temperature signals are determined by the reference voltage and the temperature-dependent resistance of the NTC thermistors 23, 24.

Figure 4 schematically illustrates a sensor system 100 according to another embodiment, wherein the circuit carrier 20 further comprises a voltage measurement circuit 31 connected to the first voltage sensing line 25 and the second voltage sensing line 26. The voltage measurement circuit 31 is configured to receive the first voltage signal via the first voltage sensing line 25 and to receive the second voltage signal via the second voltage sensing line 26. The voltage measurement circuit 31 is further configured to determine the voltage drop over the shunt resistor 10 based on the received first and second voltage signals. The voltage measurement circuit 31 may further be configured to determine the current through the shunt 10 based on the determined voltage drop and a stored value of the ohmic resistance of the measurement resistance 14. The skilled person is aware of multiple ways to design a voltage measurement circuit 31 using either analogue hardware components, such as e.g., operational amplifiers, differential amplifiers, comparators, or the like, or using integrated circuits such as e.g., ASICS, programmable microcontroller, or the like.

The sensor system 100 shown in Figure 4 further comprises a temperature measurement circuit 32 that is disposed on the circuit carrier 20 and that is configured to receive the first temperature signal via the first temperature sensing line 27 and that is configured to receive the second temperature signal via the second temperature sensing line 28. In the embodiment of Figure 4, the first and second temperature sensing lines 27, 28 also each comprise a local thinning adjacent to the respective temperature sensor 23, 24.

The temperature measurement circuit 32 is further configured to determine the temperature of the first landing pad 21 based on the received first temperature signal and to determine the temperature of the second landing pad 22 based on the received second temperature signal. Therein, the voltage drop over the shunt resistor 10 based on the current along the current path of the battery module might influence the temperature determination due to the different reference voltage underlying the first and second temperature signals. The temperature measurement circuit 32 is thus configured to communicate with the voltage measurement circuit 31 for exchanging information. Also the voltage measurement circuit 31 is configured to communicate with the temperature measurement circuit 32. The communication between the voltage measurement circuit 31 and the temperature measurement circuit 32 occurs via data communication path 33 as indicated by the dashed arrows illustrated in Figure 4.

Figure 5 illustrates a circuit diagram of a sensor system 100 according to an embodiment. The circuit diagram applies to the sensor systems 100 as schematically illustrated in Figures 3 and 4 and same elements are denoted therein by same reference signs. The sensor system 100 as shown in Figure 5 comprises the measurement resistance 14 that is disposed in a current path of a battery module. Further, a third resistor 44 and a fourth resistor 45 are disposed in the current path and are connected in series with the shunt resistor and thus the measurement resistance 14. A first voltage signal SENS+ is tapped adjacent the measurement resistance 14 via a first voltage sensing line 25 and a second voltage signal SENS- is tapped adjacent the measurement resistance 14 via a second voltage sensing line 26. The voltage sensing lines 25, 26 may provide the voltage signals SENS+, SENS- to the voltage measurement circuit 31 as illustrated in Figure 4.

Further, a first NTC thermistor 23 as a first temperature sensor is contacting the shunt resistor adjacent the measurement resistance 14, particularly at a first voltage clamp (not shown) as illustrated in each of the Figures 2 to 4. A reference voltage V_{REF} of 5 V is applied to the first temperature sensor 23 from a reference voltage source 41 and via a first resistor 42 of 10kΩ. The reference voltage V_{REF} is conducted via the measurement resistance 14 to ground 46. Due to the first resistor 42, an additional current over the shunt resistor due to the reference voltage amounts to 500 pA the most. Further, a second NTC thermistor 24 as a second temperature sensor is contacting the shunt resistor adjacent the measurement resistance, particularly at a second voltage clamp (not shown) as illustrated in each of the Figures 2 to 4. The reference voltage V_{REF} of 5 V is also applied to the second temperature sensor 24 from the reference voltage source 41 and via a second resistor 43 of 10kQ. The reference voltage V_{REF} is also conducted to ground 46. Hence, an additional current over the shunt resistor due to the reference voltage amounts to 500 µA the most. The additional current due to V_{REF} can thus be neglected in the current measurement via the shunt resistor. The voltage difference with respect to the first temperature signal on the first temperature sensing line 27 and the second temperature signal on the second temperature sensing line 28 are considered in calculating the temperature at the first temperature sensor 23 and the second temperature sensor 24, respectively. This voltage difference corresponds to the voltage drop over the measurement resistance 14, i.e., ΔV = SENS+ - SENS-, which may be determined by a voltage measurement circuit 31 as illustrated in Figure 4 and which may be communicated therefrom to a temperature measurement circuit 32 as illustrated in Figure 4.

### Reference signs

- 10: shunt resistor
- 11: first current clamp
- 12: second current clamp
- 13: contact hole
- 14: measurement resistance
- 15: first voltage clamp
- 16: second voltage clamp

- 20: circuit carrier
- 21: first landing pad
- 22: second landing pad
- 23: first temperature sensor
- 24: second temperature sensor
- 25: first voltage sensing line
- 26: second voltage sensing line
- 27: first temperature sensing line
- 28: second temperature sensing line

- 31: voltage measurement circuit
- 32: temperature measurement circuit
- 33: communication lines

- 41: reference voltage node
- 42: first (dropping) resistor
- 43: second (dropping) resistor

## Claims

1. Sensor system (100) for a battery module, comprising:
a shunt resistor (10) having
a first current clamp (11) and a second current clamp (12) that are each configured to be connected to a current path of the battery module,
a first voltage clamp (15) and a second voltage clamp (16), and
a measurement resistance (14) electrically connecting the first current clamp (11) and the second current clamp (12) and being disposed between the first voltage clamp (15) and the second voltage clamp (16) positioned adjacent the measurement resistance (14),
a first landing pad (21) electrically connected to the first voltage clamp (15) and a second landing pad (22) electrically connected to the second voltage clamp (16), wherein the first landing pad (21) and the second landing pad (22) are separated from the shunt resistor (10) and are configured for tapping voltage signals from the shunt resistor (10), and
a first temperature sensor (23) connected to the first landing pad (21) and configured to measure a temperature of the first landing pad (21) and a second temperature sensor (24) connected to the second landing pad (22) and configured for measuring a temperature of the second landing pad (22).

2. Sensor system (100) according to claim 1, wherein the first current clamp (11) and the second current clamp (12) each comprises at least one contact hole (13) configured for being connected to a terminal of a battery cell.

3. Sensor system (100) according to claim 1 or 2, wherein the measurement resistance (14) comprises of Manganin, Isotan, Constantan, and/or Isabellin.

4. Sensor system (100) according to any one of the preceding claims, wherein the current clamps (11,12) and the voltage clamps (15,16) consist of copper or aluminum.

5. Sensor system (100) according to any one of the preceding claims, further comprising:
a circuit carrier (20) configured for carrying a control unit of the battery module,
wherein the first landing pad (21) and the second landing pad (22) are formed as conductive structures on a surface of the circuit carrier (20),
wherein the shunt resistor (10) is mounted to the surface of the circuit carrier (20), and
wherein the temperature sensors (23,24) are surface mounted to the surface of the circuit carrier (20).

6. Sensor system (100) according to any one of the preceding claims, wherein the first temperature sensor (23) is a first thermistor and the second temperature sensor is a second thermistor (24).

7. Sensor system (100) according to any one of the preceding claims, wherein the first current clamp (11) is configured as a first bar element, the second current clamp (12) is configured as a second bar element and the measurement resistance (14) is configured as a third bar element that is connecting the first bar element and the second bar element to form a common bar extending in a lengthwise direction.

8. Sensor system (100) according to claim 7, wherein the first voltage clamp (15) is formed as a first protrusion extending from the first bar element in a direction angled to the lengthwise direction and the second voltage clamp (16) is formed as a second protrusion extending from the second bar element in a direction angled to the lengthwise direction.

9. Sensor system (100) according to any one of the preceding claims, wherein
the first voltage clamp (15) is connected via the first landing pad (21) to a first voltage sensing line (25) and via the first landing pad (21) and the first temperature sensor (23) to a first temperature sensing line (27), and
the second voltage clamp (16) is connected via the second landing pad (22) to a second voltage sensing line (26) and via the second landing pad (22) and the second temperature sensor (24) to a second temperature sensing line (28).

10. Sensor system (100) according to claim 9, wherein a thermal coupling between the first and second landing pads (21, 22) and at least one of the respective voltage sensing line (25, 26) and the temperature sensing lines (27, 28) is decreased.

11. Sensor system (100) according to claim 10, wherein the decreased thermal coupling of the landing pads (21, 22) to at least one of the voltage sensing line (25, 26) and/or the temperature sensing lines (27, 28) is realized by an at least local thinning (29) of the voltage sensing lines (25, 26) and/or the temperature sensing lines (27, 28)

12. Sensor system (100) according to any one of the claims 9 to 11, wherein the voltage sensing lines (25, 26) are configured for providing voltage signals to a voltage measurement circuit (31) and wherein the temperature sensing lines (27, 28) are configured for providing temperature signals to a temperature measurement circuit (32).

13. Sensor system (100) according to any one of claims 9 to 12, wherein a reference voltage node (41) is connected to the first temperature sensing line (27) via a first resistor (42) and/or to the second temperature sensing line (28) via a second resistor (43).

14. Sensor system (100) according to any one of the claims 9 to 13, wherein the voltage measurement circuit (31) and the temperature measurement circuit (32) are configured to communicate with each other.

15. Sensor system (100) according to claim 5, wherein the circuit carrier (20) carries at least one of a cell supervision circuit, CSC, a cell connecting unit, CCU, a battery management unit, BMU, and a battery management system, BMS.

## Patentansprüche

1. Sensorsystem (100) für ein Batteriemodul, bestehend aus:
einem Nebenschlusswiderstand (10) mit
einer ersten Stromzange (11) und einer zweiten Stromzange (12), die jeweils konfiguriert sind, um mit einem Strompfad des Batteriemoduls verbunden zu werden,
einer ersten Spannungsklemme (15) und einer zweiten Spannungsklemme (16), und
einem Messwiderstand (14), der die erste Stromzange (11) und die zweite Stromzange (12) elektrisch verbindet und zwischen der ersten Spannungsklemme (15) und der zweiten Spannungsklemme (16) angeordnet ist, die neben dem Messwiderstand (14) positioniert sind,
einer ersten Kontaktfläche (21), die elektrisch mit der ersten Spannungsklemme (15) verbunden ist, und einer zweiten Kontaktfläche (22), die elektrisch mit der zweiten Spannungsklemme (16) verbunden ist, wobei die erste Kontaktfläche (21) und die zweite Kontaktfläche (22) von dem Nebenschlusswiderstand (10) getrennt sind und zum Abgreifen von Spannungssignalen von dem Nebenschlusswiderstand (10) konfiguriert sind, und
einem ersten Temperatursensor (23), der mit der ersten Kontaktfläche (21) verbunden und konfiguriert ist, um eine Temperatur der ersten Kontaktfläche (21) zu messen, und einem zweiten Temperatursensor (24), der mit der zweiten Kontaktfläche (22) verbunden und konfiguriert ist, um eine Temperatur der zweiten Kontaktfläche (22) zu messen.

2. Sensorsystem (100) nach Anspruch 1, wobei die erste Stromzange (11) und die zweite Stromzange (12) jeweils mindestens ein Kontaktloch (13) aufweisen, das zum Anschluss an einen Pol einer Batteriezelle konfiguriert ist.

3. Sensorsystem (100) nach Anspruch 1 oder 2, wobei der Messwiderstand (14) Manganin, Isotan, Konstantan und/oder Isabellin umfasst.

4. Sensorsystem (100) nach einem der vorhergehenden Ansprüche, wobei die Stromzangen (11, 12) und die Spannungsklemmen (15, 16) aus Kupfer oder Aluminium bestehen.

5. Sensorsystem (100) nach einem der vorhergehenden Ansprüche, ferner Folgendes umfassend:
einen Schaltungsträger (20), der zum Tragen einer Steuereinheit des Batteriemoduls konfiguriert ist,
wobei die erste Kontaktfläche (21) und die zweite Kontaktfläche (22) als leitende Strukturen auf einer Oberfläche des Schaltungsträgers (20) ausgebildet sind,
wobei der Nebenschlusswiderstand (10) auf der Oberfläche des Schaltungsträgers (20) montiert ist, und
wobei die Temperatursensoren (23, 24) an der Oberfläche des Schaltungsträgers (20) oberflächenmontiert sind.

6. Sensorsystem (100) nach einem der vorhergehenden Ansprüche, wobei der erste Temperatursensor (23) ein erster Thermistor und der zweite Temperatursensor ein zweiter Thermistor (24) ist.

7. Sensorsystem (100) nach einem der vorhergehenden Ansprüche, wobei die erste Stromzange (11) als erstes Stabelement konfiguriert ist, die zweite Stromzange (12) als zweites Stabelement konfiguriert ist und der Messwiderstand (14) als drittes Stabelement konfiguriert ist, das das erste Stabelement und das zweite Stabelement zu einem gemeinsamen, in Längsrichtung verlaufenden Stab verbindet.

8. Sensorsystem (100) nach Anspruch 7, wobei die erste Spannungsklemme (15) als ein erster Vorsprung ausgebildet ist, der sich von dem ersten Stabelement in einer Richtung winkelförmig zur Längsrichtung erstreckt, und die zweite Spannungsklemme (16) als ein zweiter Vorsprung ausgebildet ist, der sich von dem zweiten Stabelement in einer Richtung winkelförmig zur Längsrichtung erstreckt.

9. Sensorsystem (100) nach einem der vorhergehenden Ansprüche, wobei
die erste Spannungsklemme (15) über die erste Kontaktfläche (21) mit einer ersten Spannungsmessleitung (25) und über die erste Kontaktfläche (21) und den ersten Temperatursensor (23) mit einer ersten Temperaturmessleitung (27) verbunden ist, und
die zweite Spannungsklemme (16) über die zweite Kontaktfläche (22) mit einer zweiten Spannungsmessleitung (26) und über die zweite Kontaktfläche (22) und den zweiten Temperatursensor (24) mit einer zweiten Temperaturmessleitung (28) verbunden ist.

10. Sensorsystem (100) nach Anspruch 9, wobei eine thermische Kopplung zwischen der ersten und der zweiten Kontaktfläche (21, 22) und mindestens einer der jeweiligen Spannungsmessleitungen (25, 26) und der Temperaturmessleitungen (27, 28) verringert ist.

11. Sensorsystem (100) nach Anspruch 10, wobei die verringerte thermische Kopplung der Kontaktflächen (21, 22) mit mindestens einer der Spannungsmessleitungen (25, 26) und/oder der Temperaturmessleitungen (27, 28) durch eine mindestens lokale Ausdünnung (29) der Spannungsmessleitungen (25, 26) und/oder der Temperaturmessleitungen (27, 28) realisiert wird.

12. Sensorsystem (100) nach einem der Ansprüche 9 bis 11, wobei die Spannungsmessleitungen (25, 26) so konfiguriert sind, dass sie Spannungssignale an eine Spannungsmessschaltung (31) liefern, und wobei die Temperaturmessleitungen (27, 28) so konfiguriert sind, dass sie Temperatursignale an eine Temperaturmessschaltung (32) liefern.

13. Sensorsystem (100) nach einem der Ansprüche 9 bis 12, wobei ein Referenzspannungsknoten (41) über einen ersten Widerstand (42) mit der ersten Temperaturmessleitung (27) und/oder über einen zweiten Widerstand (43) mit der zweiten Temperaturmessleitung (28) verbunden ist.

14. Sensorsystem (100) nach einem der Ansprüche 9 bis 13, wobei die Spannungsmessschaltung (31) und die Temperaturmessschaltung (32) so konfiguriert sind, dass sie miteinander kommunizieren.

15. Sensorsystem (100) nach Anspruch 5, wobei der Schaltungsträger (20) mindestens eines einer Zellüberwachungsschaltung, CSC, einer Zellverbindungseinheit, CCU, einer Batteriemanagementeinheit, BMU, und eines Batteriemanagementsystem, BMS, trägt.

## Revendications

1. Système de capteur (100) pour un module de batterie, comprenant :
une résistance shunt (10) présentant
une première pince de courant (11) et une deuxième pince de courant (12) qui sont chacune configurées pour être connectées à un chemin de courant du module de batterie,
une première pince de tension (15) et une deuxième pince de tension (16), et
une résistance de mesure (14) connectant électriquement la première pince de courant (11) et la deuxième pince de courant (12) et étant disposée entre la première pince de tension (15) et la deuxième pince de tension (16) positionnées de manière adjacente à la résistance de mesure (14),
une première plage de connexion (21) électriquement connectée à la première pince de tension (15) et une deuxième plage de connexion (22) électriquement connectée à la deuxième pince de tension (16), dans lequel la première plage de connexion (21) et la deuxième plage de connexion (22) sont séparées de la résistance shunt (10) et sont configurées pour recueillir les signaux de tension de la résistance shunt (10), et
un premier capteur de température (23) connecté à la première plage de connexion (21) et configuré pour mesurer une température de la première plage de connexion (21) et un deuxième capteur de température (24) connecté à la deuxième plage de connexion (22) et configuré pour mesurer une température de la deuxième plage de connexion (22).

2. Système de capteur (100) selon la revendication 1, dans lequel la première pince de courant (11) et la deuxième pince de courant (12) comprennent chacune au moins un trou de contact (13) configuré pour être connecté à une borne d'une cellule de batterie.

3. Système de capteur (100) selon la revendication 1 ou 2, dans lequel la résistance de mesure (14) est composée de manganine, d'isotan, de constantan, et/ou d'isabellin.

4. Système de capteur (100) selon l'une quelconque des revendications précédentes, dans lequel les pinces de courant (11, 12) et les pinces de tension (15, 16) sont constituées de cuivre ou d'aluminium.

5. Système de capteur (100) selon l'une quelconque des revendications précédentes, comprenant en outre :
un support de circuit (20) configuré pour porter une unité de commande du module de batterie,
dans lequel la première plage de connexion (21) et la deuxième plage de connexion (22) sont formées comme des structures conductrices sur une surface du support de circuit (20),
dans lequel la résistance shunt (10) est montée sur la surface du support de circuit (20), et
dans lequel les capteurs de température (23, 24) sont montés en surface sur la surface du support de circuit (20).

6. Système de capteur (100) selon l'une quelconque des revendications précédentes, dans lequel le premier capteur de température (23) est une première thermistance et le deuxième capteur de température est une deuxième thermistance (24).

7. Système de capteur (100) selon l'une quelconque des revendications précédentes, dans lequel la première pince de courant (11) est configurée comme un premier élément formant barre, la deuxième pince de courant (12) est configurée comme un deuxième élément formant barre et la résistance de mesure (14) est configurée comme un troisième élément formant barre qui connecte le premier élément formant barre et le deuxième élément formant barre pour former une barre commune s'étendant dans une direction longitudinale.

8. Système de capteur (100) selon la revendication 7, dans lequel la première pince de tension (15) est formée comme une première saillie s'étendant à partir du premier élément formant barre dans une direction en angle par rapport à la direction longitudinale et la deuxième pince de tension (16) est formée comme une deuxième saillie s'étendant à partir du deuxième élément formant barre dans une direction en angle par rapport à la direction longitudinale.

9. Système de capteur (100) selon l'une quelconque des revendications précédentes, dans lequel
la première pince de tension (15) est connectée par le biais de la première plage de connexion (21) à une première ligne de détection de tension (25) et par le biais de la première plage de connexion (21) et du premier capteur de température (23) à une première ligne de détection de température (27), et
la deuxième pince de tension (16) est connectée par le biais de la deuxième plage de connexion (22) à une deuxième ligne de détection de tension (26) et par le biais de la deuxième plage de connexion (22) et du deuxième capteur de température (24) à une deuxième ligne de détection de température (28).

10. Système de capteur (100) selon la revendication 9, dans lequel un couplage thermique entre les première et deuxième plages de connexion (21, 22) et au moins une de la ligne de détection de tension (25, 26) respective et des lignes de détection de température (27, 28) est diminué.

11. Système de capteur (100) selon la revendication 10, dans lequel le couplage thermique diminué des plages de connexion (21, 22) à au moins une de la ligne de détection de tension (25, 26) et/ou des lignes de détection de température (27, 28) est réalisé par un amincissement (29) au moins local des lignes de détection de tension (25, 26) et/ou des lignes de détection de température (27, 28)

12. Système de capteur (100) selon l'une quelconque des revendications 9 à 11, dans lequel les lignes de détection de tension (25, 26) sont configurées pour fournir des signaux de tension à un circuit de mesure de tension (31) et dans lequel les lignes de détection de température (27, 28) sont configurées pour fournir des signaux de température à un circuit de mesure de température (32).

13. Système de capteur (100) selon l'une quelconque des revendications 9 à 12, dans lequel un noeud de tension de référence (41) est connecté à la première ligne de détection de température (27) par le biais d'une première résistance (42) et/ou à la deuxième ligne de détection de température (28) par le biais d'une deuxième résistance (43).

14. Système de capteur (100) selon l'une quelconque des revendications 9 à 13, dans lequel le circuit de mesure de tension (31) et le circuit de mesure de température (32) sont configurés pour communiquer l'un avec l'autre.

15. Système de capteur (100) selon la revendication 5, dans lequel le support de circuit (20) porte au moins un d'un circuit de supervision de cellule, CSC, d'une unité de connexion de cellule, CCU, d'une unité de gestion de batterie, BMU, et d'un système de gestion de batterie, BMS.
